# EUROPEAN PATENT APPLICATION

(11) **EP 3 410 502 A1**
(43) Date of publication of application: **05.12.2018**
(21) Application number: 18174448.3
(22) Date of filing: 25.05.2018
(51) Int. Cl.: H01L 35/30, F02G 5/00, F02M 53/00, F02M 55/00, F02M 63/00, F02M 37/00

(54) **FUEL INJECTOR EQUIPMENT**

(30) Priority: 01.06.2017 GB 201708759
(71) Applicant: Delphi Technologies IP Limited, Saint Michael (BB)
(72) Inventor: LLOYD, James, Maidstone, Kent ME17 1HJ (GB)
(74) Representative: Delphi France SAS

(57) **Abstract**

A Seebeck generator (26) is arranged between a hot fuel flow and a cold fuel flow of a fuel injection equipment.

## Description

### TECHNICAL FIELD

The present invention relates to a diesel fuel injection equipment provided with a Seebeck electrical generator arranged between a cold and a hot conduits of said equipment.

### BACKGROUND OF THE INVENTION

Diesel fuel injection equipment of an internal combustion engine comprises a cold circuit, with a high pressure pump upstream and a hot circuit downstream of said pump. After being compressed to thousands of bars, part of the hot fuel is not injected in the engine cylinders but decompresses and returns at low pressure back to a tank. Said fraction returned to the tank represents an important loss of energy.

### SUMMARY OF THE INVENTION

Accordingly, it is an object of the present invention to resolve the above mentioned problems in providing a generator assembly adapted to be arranged in a cold circuit and a hot circuit of a fuel injection equipment, said generator comprising a body, defining a cold inner channel wherein, in use, flows a cold fuel flow and, a hot inner channel wherein in use flows a hot fuel flow and wherein a Seebeck generator is arranged between said channels. One side of the Seebeck generator is wetted by the cold flow and the opposite side being wetted by the hot flow.

Particularly, said generator assembly comprises a hot member and a cold member, the hot inner channel being defined in the hot member and, the cold inner channel being defined in the cold member.

The invention further extends to a fuel injection equipment for an internal combustion engine, said fuel equipment defining a cold circuit and a hot circuit, the cold circuit comprising a cold conduit in which, in use, cold fuel stored in a tank is drawn and flown to a high pressure pump. The hot circuit comprising a hot conduit in which, in use, hot fuel flows back from a common rail and returns to said tank. The injection equipment further comprises a generator assembly as claimed in any of the preceding claims arranged between said cold and hot conduits.

Also, the hot fuel used to control the moves of a needle valve member of fuel injectors return from said fuel injectors to said tank joining and flowing in said hot conduit upstream said generator.

Also, the hot conduit joins the cold conduit between said tank and a fuel filter arranged upstream said high pressure pump, the injection equipment further comprising a check valve preventing cold fuel to flow in the hot conduit, said check valve being arranged on the hot conduit, between the generator assembly and the junction with the cold conduit.

### BRIEF DESCRIPTION OF THE DRAWINGS

The present invention is now described by way of example with reference to the accompanying drawings in which:
Figure 1 is a diagram of a fuel injection equipment comprising a Seebeck generator as per the invention.
Figure 2 is a magnified area of figure 1.
Figure 3 is a theoretical Seebeck generator.
Figure 4 is an example embodiment of the Seebeck generator of figure 1.

### DESCRIPTION OF THE PREFERRED EMBODIMENTS

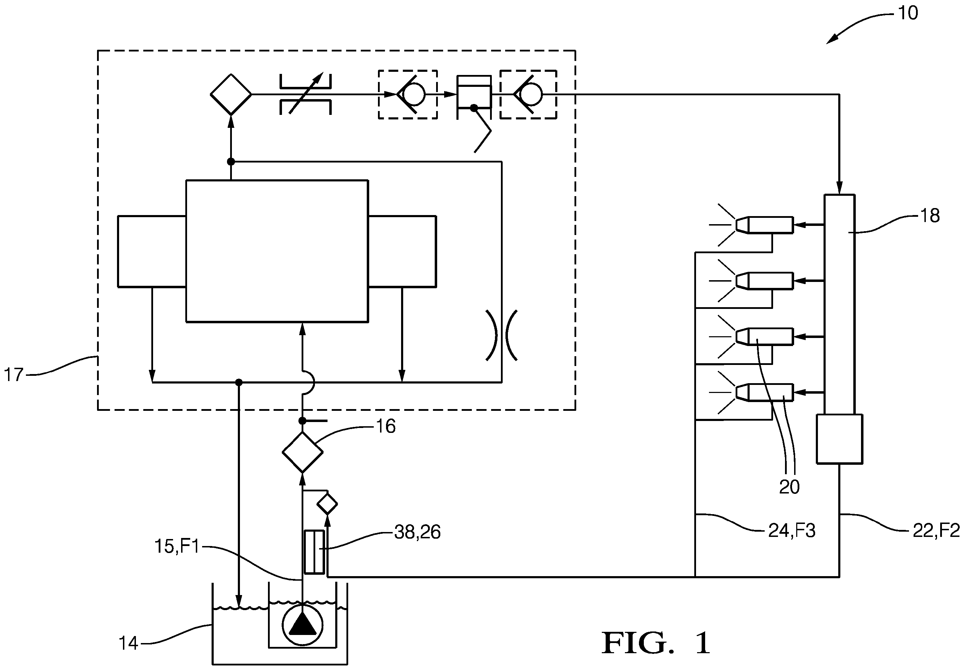

A diesel fuel injection equipment 10 of an internal combustion engine, represented in figure 1, is controlled by an electronic command unit that computes and sends command signals to the components of said equipment based on information signals relevant to the needs for fulfilling the engine torque and power requirements.

The injection equipment 10 defines a general flow circuit for the diesel fuel stored in a low pressure tank 14 to be sucked or pumped out so that an initial fuel flow F1 is flown in an first conduit 15 going to a filter 16 and to a high pressure pump 17 where said initial flow F1 is pressurised then delivered to a common rail 18 wherefrom a main fraction of the compressed fuel is distributed to fuel injectors 20 and an in-excess fraction is decompressed and returned forming a rail return flow F2 to the tank 14 via a rail return line 22. The main fraction going to the injectors 20 is also divided in a fraction injected in the cylinders of the engine and, in another fraction serving to operate the injectors, said latter operational fraction being afterward decompressed forming an injector return flow F3 returned to the tank 14 via an injector return line 24. Although the initial flow F1 is cold, or at room temperature, the rail return flow F2 and the injector return flow F3 are hot after having been compressed to thousands of bars and then decompressed to around atmospheric pressure.

The injection equipment 10 further comprises a Seebeck generator 26 adapted to produce electrical power from said hot F2, F3 and cold F1 flows.

As shown on the figures said Seebeck generator 26 is arranged between the tank 14 and the filter 16, the initial flow F1 cooling a cold side 28 of the generator 26 and the two return flows F2, F3 heating a hot side 30 of the generator. On the figure is shown an embodiment where the injector return flow F2 and the rail return flow F3 join upstream the Seebeck generator 26 when, in an alternative the two return flows F2, F3 remain in distinct conduit from one another and only merge when joining the generator. When exiting the generator 26, the hot flows F2, F3 can be sent back to the tank 14 or, as shown on the figure, they can combine and flow in a hot outlet conduit 29 from the generator hot outlet 32 to a junction 34 where it merges with the first conduit 15 upstream the filter. In such alternative, as shown, a non-return check valve 36 is arranged on said hot outlet conduit 29 in order to prevent cold flow to enter the generator 26 via the hot outlet 32.

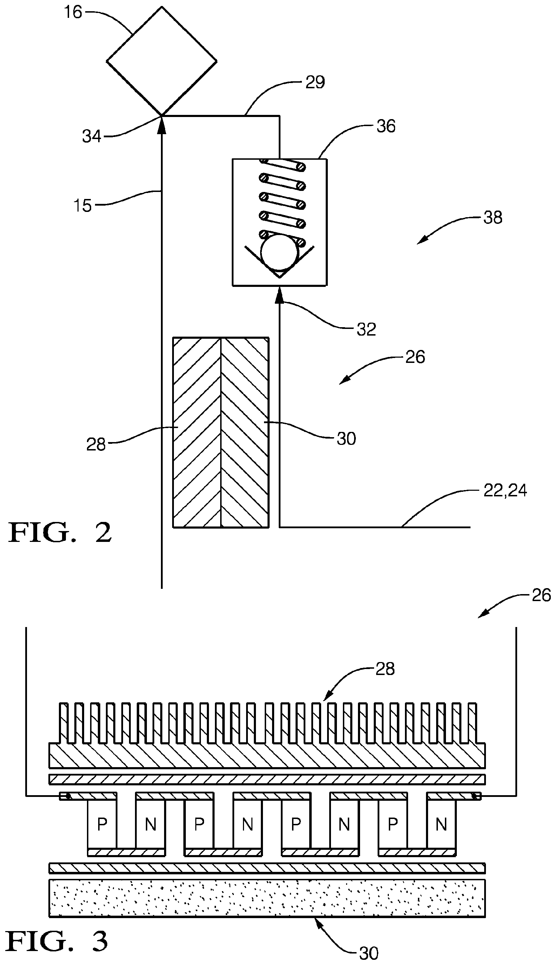

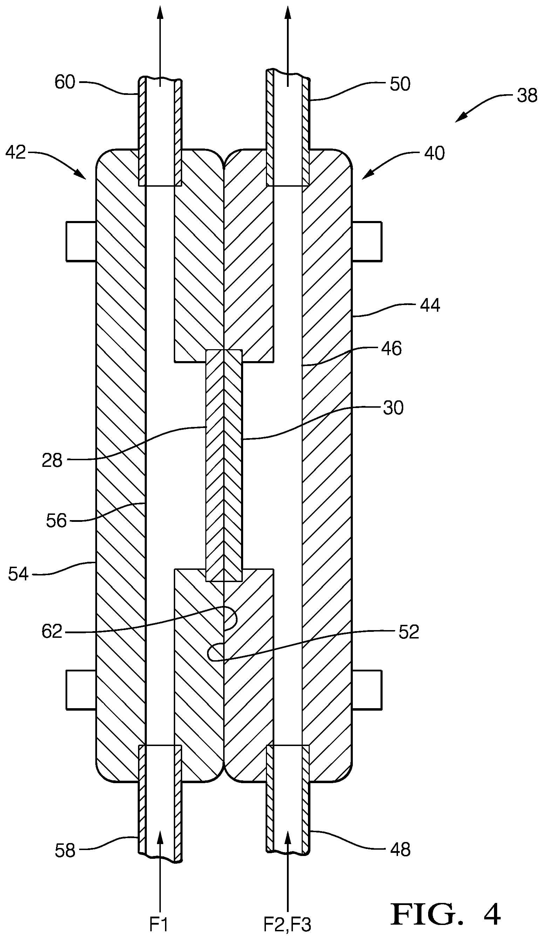

Figure 3 shows a theoretical Seebeck generator wherein a plurality of thermoelectric modules is arranged one side on a hot source and the opposite side on the cold source. Under the hot/cold influence the thermoelectric generators produce electricity. A possible embodiment is presented on figure 4 wherein a generator assembly 38 comprises the Seebeck generator 26 arranged between symmetrical hot 40 and cold 42 members.

Said hot member 40 defines within a hot body 44 a hot inner channel 46 extending from a hot inlet 48 to a hot outlet 50 and wherein flows the hot flows, F3. Said hot body 44 is further provided with an inner opening arranged on an inner face 52, said opening joining said hot inner channel 46 and the Seebeck generator 26 being arranged to sealingly close said opening so one side of the generator is wetted by said hot flows F2, F3.

Symmetrically, said cold member 42 defines within a cold body 54 a cold inner channel 56 extending from a cold inlet 58 to a cold outlet 60 and wherein flows the cold initial flow F1. Said cold body 54 is further provided with an inner opening arranged on an inner face 62, said opening joining said cold inner channel 56 and the Seebeck generator 26 being complementary arranged to sealingly close said opening so the opposite side of the generator is wetted by said cold flow F1.

As shown on the figure the hot 40 and cold 42 members are arranged against one another, the inner face 52 of the hot member being pressed against the inner face 62 of the cold member, the hot body 44 and the cold body 54 forming a single body in which the Seebeck generator 26 is housed, sandwiched between said two members. As sketched, said two members are tightened against one another via fixation bolts or any other means.

In an alternative not shown the check valve 36 can be arranged housed in one of said hot or cold body.

### LIST OF REFERENCES

- F1: initial flow
- F2: rail return flow
- F3: injector return flow

- 10: fuel injection equipment
- 14: tank
- 15: first conduit
- 16: filter
- 17: high pressure pump
- 18: common rail
- 20: fuel injector
- 22: rail return line
- 24: injector return line
- 26: Seebeck generator
- 28: cold side
- 29: hot outlet conduit
- 30: hot side
- 32: hot outlet
- 34: junction
- 36: check valve
- 38: generator assembly
- 40: hot member
- 42: cold member
- 44: hot body
- 46: hot inner channel
- 48: hot inlet
- 50: hot outlet
- 52: inner face of the hot body
- 54: cold body
- 56: cold inner channel
- 58: cold inlet
- 60: cold outlet
- 62: inner face of the cold body

## Claims

1. Generator assembly (38) adapted to be arranged in a cold circuit and a hot circuit of a fuel injection equipment (10), said generator (38) comprising a body (44, 54) defining a cold inner channel (56) wherein, in use, flows a cold fuel flow (F1) and, a hot inner channel (46) wherein in use flows a hot fuel flow (F2, F3) and wherein a Seebeck generator (26) is arranged between said channels, one side of the Seebeck generator being wetted by the cold flow (F1) and the opposite side being wetted by the hot flow (F2, F3).

2. Generator assembly (38) as claimed in the preceding claim comprising a hot member (40) and a cold member (42), the hot inner channel (46) being defined in the hot member (40) and, the cold inner channel (56) being defined in the cold member (42).

3. Fuel injection equipment (10) for an internal combustion engine, said fuel equipment defining a cold circuit and a hot circuit,
the cold circuit comprising a cold conduit in which, in use, cold fuel stored in a tank (14) is drawn and flown (F1) to a high pressure pump and,
the hot circuit comprising a hot conduit in which, in use, hot fuel flows (F2, F3) back from a common rail and returns to said tank (14) and wherein,
the injection equipment (10) further comprises a generator assembly (38) as claimed in any of the preceding claims arranged between said cold and hot conduits.

4. Fuel injection equipment (10) as claimed claim 3 wherein hot fuel used to control the moves of a needle valve member of fuel injectors return from said fuel injectors to said tank joining and flowing in said hot conduit upstream said generator.

5. Fuel injection equipment (10) as claimed in any of the claims 3 or 4 wherein the hot conduit joins the cold conduit between said tank (14) and a fuel filter arranged upstream said high pressure pump, the injection equipment further comprising a check valve (36) preventing cold fuel to flow in the hot conduit, said check valve being arranged on the hot conduit, between the generator assembly and the junction with the cold conduit.
